# EUROPÄISCHE PATENTANMELDUNG

(11) **EP 2 028 695 A1**
(43) Veröffentlichungstag der Anmeldung: **25.02.2009**
(21) Anmeldenummer: 07013716.1
(22) Anmeldetag: 12.07.2007
(51) Int. Cl.: H01L 31/0224, H01L 31/18, C23C 14/08, H01L 31/0336, H01L 31/072

(54) **Verfahren zur Erzeugung einer transparenten leitfähigen Oxidbeschichtung**

(71) Anmelder: Applied Materials, Inc., Santa Clara, CA 95054 (US)
(72) Erfinder: Müller, Joachim, 70736 Fellbach (DE); Liu, Jian, 63538 Grosskrotzenburg (DE); Wieder, Stephan, 60385 Frankfurt (DE)
(74) Vertreter: Bockhorni & Kollegen

(57) **Zusammenfassung**

Die vorliegende Erfindung betrifft ein Verfahren zur Erzeugung einer transparenten leitfähigen Oxidbeschichtung (TCO-Schicht), insbesondere einer transparenten leitfähigen Oxidbeschichtung als transparenter Kontakt für Dünnschichtsolarzellen. Dabei besteht die TCO-Schicht mindestens aus einer ersten Schicht mit hoher Leitfähigkeit und einer zweiten Schicht mit geringer Leitfähigkeit, wobei die zweite Schicht durch DC-Sputtern von mindestens einem Target (4) erzeugt wird, die Zinkoxid und zusätzlich Aluminium aufweisen und die Prozessatmosphäre Sauerstoff enthält. Weiterhin betrifft die vorliegende Erfindung eine TCO-Schicht sowie Dünnschichtsolarzellen auf CIGS- und CdTe-Basis.

## Beschreibung

Die vorliegende Erfindung betrifft ein Verfahren zur Erzeugung einer transparenten leitfähigen Oxidbeschichtung gemäß Oberbegriff von Anspruch 1, eine transparente leitfähige Oxidbeschichtung gemäß Anspruch 13 und Dünnschichtsolarzellen gemäß den Oberbegriffen der Ansprüche 16 und 17.

Insbesondere für photovoltaische Anwendungen, wie Solarzellen und Solarmodule benötigt man transparente leitfähige Kontakte. Hierzu werden zumeist transparente leitfähige Oxidschichten (TCO-Schicht) verwendet, wobei bisher zumeist Indiumzinnoxid (ITO) zum Einsatz kam. Mittlerweile erfreut sich aber Zinkoxid (ZnO) in der industriellen Anwendung großer Beliebtheit, da es vor allem kostengünstiger als ITO abscheidbar ist.

Es ist bekannt, dass vor allem ein zweiteiliger Aufbau der auf Zinkoxid basierenden TCO-Schicht optische und elektrische Eigenschaften aufweist, die einer ITO-Schicht vergleichbar gut sind. Aus der US 5,078,804 ist dabei ein Aufbau bekannt, mit einer ersten ZnO-Schicht mit einem hohen elektrischen Widerstand (niedrige Leitfähigkeit) und einer zweiten ZnO-Schicht mit einem niedrigen elektrischen Widerstand (hohe Leitfähigkeit), wobei die erste ZnO-Schicht auf einer den Absorberbereich einer Kupferindiumgalliumdiselenid (CIGS) bedeckenden Pufferschicht angeordnet ist. Beide ZnO-Schichten werden durch RF-Magnetronsputtern in einer Sauerstoff-Argon-Atmosphäre bzw. einer reinen Argonatmosphäre abgeschieden. Weiterhin ist aus der US 2005/0109392 A1 ein CIGS-Solarzellenaufbau bekannt, bei dem die Pufferschicht ebenfalls mit einer so genannten intrinsischen, d.h. reinen ZnO-Schicht (i-ZnO) bedeckt ist, die einen hohen elektrischen Widerstand aufweist, und daran anschließend eine ZnO-Schicht aufgebracht ist, die mit Aluminium dotiert ist und einen geringen elektrischen Widerstand aufweist. Die i-ZnO-Schicht wird dabei durch RF-Magnetronsputtern abgeschieden und die ZnO-Schicht mit hoher Leitfähigkeit wird durch Magnetronsputtern vom Aluminium dotierten ZnO-Target abgeschieden. Dieses Aluminium dotierte ZnO-Target kann auch DC-gesputtert werden, was die Beschichtungsrate gegenüber RF-gesputterten Targets wesentlich erhöht. Daher wird in der industriellen Anwendung DC-Sputtem für die Abscheidung der leitfähigen ZnO:Al-Schicht genutzt.

Diese TCO-Schichten weisen eine typische Dicke von etwa 1 µm auf, wobei die Schicht mit geringer Leitfähigkeit eine Schichtdicke im Bereich von etwa 50 nm aufweist. Die Schicht mit hoher Leitfähigkeit besitzt einen spezifischen Widerstand von etwa 5 x 10⁻⁴ bis 1 x 10⁻³ Ω cm. Die i-ZnO-Schicht wird typischerweise durch RF-Sputtern bei 13,56 MHz von einem undotierten keramischen ZnO-Target erzeugt.

Durch die ZnO-Schicht mit niedriger Leitfähigkeit verbessert sich entscheidend die Wirksamkeit der Solarzelle, was dadurch erklärt wird, dass diese Schicht Defekte der Pufferschicht blockiert und so die Gefahr bzw. die Auswirkung von Kurzschlüssen in der Solarzelle und damit deren durchschnittlichen Wirkungsgrad sowie Lebensdauer erhöht.

Nachteilig an einer solchermaßen aufgebauten TCO-Schicht ist es aber, dass die ZnO-Schicht mit geringer Leitfähigkeit durch RF-Sputtern hergestellt werden muss. Das RF-Sputtern erlaubt nämlich im Vergleich zu DC-Sputtertechniken nur geringe Beschichtungsraten. Desweiteren sind der RF-Generator sowie das notwendige Anpassungsnetzwerk deutlich teurer als DC-Generatoren. Außerdem müssen die Kathode und die Beschichtungsanlage selbst besonderen Anforderungen des RF-Sputterns genügen, wie beispielsweise der RF-Dichtigkeit. Dadurch wird die Beschichtungsanlage aufwendiger, komplizierter aufgebaut und teurer. Schließlich besteht die Notwendigkeit, unterschiedliche Targetmaterialien für die ZnO-Schichten mit niedriger und hoher Leitfähigkeit bereitzuhalten, da nur ein Aluminium dotiertes Target auch DC-gesputtert werden kann, hiervon sich aber keine i-ZnO-Schichten erzeugen lassen. Generell besteht außerdem die Notwendigkeit, unterschiedliche Kathodentypen bereitzuhalten.

Aufgabe der vorliegenden Erfindung ist es deshalb, die oben genannten Nachteile zu beseitigen, d.h. ein Verfahren bereitzustellen mit dem transparente leitfähige Oxidbeschichtungen herstellbar sind, die ZnO-Schichten mit geringer Leitfähigkeit beinhalten, die mit anderen als RF-Abscheidetechniken und insbesondere unkomplizierter und kostengünstiger erzeugt werden. Insbesondere soll der Wirkungsgrad einer mit einer solchen TCO-Schicht hergestellten Solarzelle nicht geringer sein, als derjenige einer Solarzelle, deren ZnO-Schicht mit geringer Leitfähigkeit mittels RF-Sputtern hergestellt wurde. In diesem Zusammenhang sollen somit auch TCO-Schichten sowie Dünnschichtsolarzellen zur Verfügung gestellt werden.

Diese Aufgabe wird gelöst durch ein Verfahren nach Anspruch 1, eine TCO-Schicht nach Anspruch 13 und Dünnschichtsolarzellen nach Anspruch 16 und 17. Vorteilhafte Weiterbildungen dieser Gegenstände sind Inhalt der abhängigen Unteransprüche.

Das erfindungsgemäße Verfahren zeichnet sich dadurch aus, dass die Schicht mit geringer Leitfähigkeit durch DC-Sputtern von mindestens einem Zinkoxid-Target erzeugt wird, das zusätzlich Aluminium, Indium, Gallium oder Bor oder eine Kombination dieser Dotierstoffe aufweist, wobei die Prozessatmosphäre Sauerstoff enthält und Aluminium als Dotierstoff bevorzugt wird. Die Erfinder haben dabei ausgenutzt, dass durch den Sauerstoffgehalt in der Prozessatmosphäre sich auch beim DC-Sputtern von Aluminium dotierten ZnO-Targets Schichten mit geringer Leitfähigkeit herstellen lassen. Eine solchermaßen hergestellte Aluminium dotierte ZnO-Schicht (ZnO:Al-Schicht) kann die mit RF-Sputtern hergestellte i-ZnO-Schicht ersetzen, wobei der Wirkungsgrad der auf dieser TCO-Schicht basierenden Solarzellen gleich oder höher ist als derjenige von Solarzellen mit einer i-ZnO enthaltenden TCO-Schicht. Damit lassen sich gleich gute bzw. sogar Solarzellen mit höheren Wirkungsgraden bei deutlich verbessertem Produktionsdurchsatz und geringeren Equipmentkosten herstellen, da sich DC-gesputterte ZnO:Al-Schichten wesentlich schneller in ausreichender Dicke abscheiden lassen als RF-gesputterte i-ZnO-Schichten. Insbesondere wird der prozess- und anlagentechnisch sehr schwierige und aufwändige RF-Prozess vermieden.

Vorteilhaft beträgt der Sauerstoffgehalt in der Prozessatmosphäre höchstens 3%, da sich so ZnO:Al-Schichten mit sehr niedriger Leitfähigkeit herstellen lassen. Insbesondere soll der Sauerstoffgehalt höchstens 2% und bevorzugt höchstens 1% betragen. So lassen sich Schichtwiderstände von 5 · 10⁻² Ω bis ca. 10⁹ Ω erzielen.

Um diesen geringen Sauerstoffgehalt im Prozessgas genauer einstellen zu können ist es vorteilhaft, wenn die Gaszuführung nicht über einen Gasflussregler (MFC) mit sehr kleinem Nenndurchfluss für das reine Reaktivgas (Sauerstoff) und über einen weiteren Gasflussregler mit großem Nenndurchfluss für das reine Edelgas erfolgt, sondern als Reaktivgas eine konstante Mischung aus Sauerstoff und Edelgas verwendet wird, dem ein zusätzlicher Anteil von reinem Edelgas beigemischt wird. Auf diese Weise ist es möglich, den Gasflussregler (MFC) für das Reaktivgas relativ groß auslegen zu können, wodurch der geringe Anteil des Sauerstoffs in der Prozessgasatmosphäre genauer eingehalten werden kann.

Wenn die Schicht mit niedriger Leitfähigkeit mittels gepulstem DC-Sputtern erzeugt wird, kann die Prozessstabilität verbessert und dadurch die Abscheidungsrate vorteilhaft weiter erhöht werden, da höhere Leistungsdichten möglich sind. Eine Erhöhung der Prozessstabilität kann auch durch die Verwendung von Mittelfrequenzsputtern (MF-Sputtern) von mindestens zwei Targets erzielt werden. Unter DC-Sputtern im Rahmen der vorliegenden Erfindung wird demzufolge DC-Sputtern, gepulstes DC-Sputtern und MF-Sputtern verstanden.

Bevorzugt umfasst die Schicht mit hoher Leitfähigkeit Aluminium dotiertes Zinkoxid, das mittels DC-Sputtern erzeugt wurde, allerdings können auch andere transparente Oxidschichten mit hoher Leitfähigkeit, wie ITO und dergleichen, verwendet werden.

Vorteilhaft kommt als Target des DC-Sputterns der zweiten Schicht ein keramisches Target zum Einsatz, das sowohl Zinkoxid als auch Aluminiumoxid enthält. Bei einem solchen ZnO:Al₂O₃-Target handelt es sich um eine Mischkeramik, die typischerweise durch Pressen oder Sintern herstellbar ist. Alternativ sind auch metallische Targets verwendbar, die aus einer Zn-Al-Legierung mit einigen Gew.-% Aluminium bestehen. Durch Zugabe von Sauerstoff lässt sich im Reaktivprozess hiervon ZnO:Al sputtern.

In einer besonders bevorzugten Ausführungsform werden sowohl die Schicht mit hoher als auch die mit geringer Leitfähigkeit durch Sputtern vom gleichen Targetmaterial erzeugt, wobei sie vorteilhaft auch vom selben Target erzeugt werden und dann die Schicht mit hoher Leitfähigkeit in einer Inertgasatmosphäre und die Schicht mit geringer Leitfähigkeit in einer Sauerstoff- oder gemischten Inertgas-Sauerstoff-Prozessatmosphäre erzeugt werden.

Insbesondere wenn im Vergleich zur Substratoberfläche Sputterkathoden mit geringerer Ausdehnung eingesetzt werden sollen, ist es denkbar, dass das zu beschichtende Substrat, das auch schon eine Beschichtung aufweisen kann, eine pendelnde Bewegung in einer hinsichtlich der Abscheiderichtung der Sputterquelle senkrechten Richtung ausführt. Dann lässt sich durch mehrere Pendelbewegungen des Substrates die Substratoberfläche mehrfach an der Kathode vorbeibewegen, und so die gewünschte Schichtdicke einstellen.

Alternativ kann auch ein in-line-Verfahren verwendet werden, bei dem das Substrat an mehreren gleichartigen, hintereinander angeordneten Sputterquellen vorbeigeführt wird, die das gleiche Targetmaterial aufweisen. Die gewünschte Schichtdicke lässt sich dann über die an die Beschichtungsraten angepasst Transportgeschwindigkeit einstellen.

Bevorzugt und als Schritt zur Herstellung CIGS-artiger Solarzellen und -module wird ein Substrat, insbesondere Glassubstrat, auf dem sich ein vom Substrat ausgehender wesentlicher Schichtaufbau mit einer Metallschicht mit wenigstens einem der Metalle Molybdän, Niob, Kupfer, Nickel, Silber und Aluminium, einer Schicht aus der Gruppe Kupferindiumdiselenid, Kupferindiumgalliumdiselenid, Kupfergalliumdiselenid und Kupferindiumsulfid und einer weiteren Schicht aus der Gruppe Kadmiumzinksulfid, Kadmiumtellurid, Kadmiumsulfid, Zinksulfid und Zink-Magnesium-Oxid befindet, mit der Schicht mit geringer Leitfähigkeit und anschließend mit der Schicht mit hoher Leitfähigkeit beschichtet.

Bevorzugt und als Schritt zur Herstellung CdTe-artiger Solarzellen und -module wird ein Substrat, insbesondere Glassubstrat, mit der Schicht mit hoher Leitfähigkeit und anschließend mit der Schicht mit geringer Leitfähigkeit beschichtet, wonach ein vom Substrat ausgehender wesentlicher Schichtaufbau mit einer Kadmiumsulfidschicht, einer Kadmiumtelluridschicht und einer Metallschicht mit wenigstens einem der Metalle Molybdän, Niob, Kupfer, Nickel, Silber und Aluminium aufgebracht wird.

Unabhängiger Schutz wird beansprucht für eine transparente leitfähige Oxidbeschichtung, insbesondere als transparenter Kontakt für Dünnschichtsolarzellen, die mindestens eine Schicht mit einer hohen Leitfähigkeit und eine Schicht mit einer wesentlich geringeren Leitfähigkeit umfasst, wobei die Schicht mit niedriger Leitfähigkeit Aluminium dotiertes Zinkoxid umfasst, das in einer Prozessatmosphäre, die Sauerstoff enthält, abgeschieden wurde. Bevorzugt ist diese transparente leitfähige Beschichtung nach dem oben dargestellten erfindungsgemäßen Verfahren hergestellt. Vorteilhaft umfasst die Schicht mit hoher Leitfähigkeit Aluminium dotiertes Zinkoxid, das mittels DC-Sputtern erzeugt wurde. Zusätzlich können zwischen den Schichten mit hoher und niedriger Leitfähigkeit ein oder mehrere weitere Schichten angeordnet sein, die ebenfalls eine hohe Leitfähigkeit aufweisen. Dadurch kann die transparente leitfähige Beschichtung noch besser speziellen Bedingungen angepasst werden. Beispielsweise kann ein definierter Verlauf der Leitfähigkeit senkrecht zur Schichtabfolge eingestellt werden.

Ebenfalls selbständiger Schutz wird beansprucht für Dünnschichtsolarzellen, die eine solche transparente leitfähige Oxidschicht aufweisen. Und zwar zum einen für CIGS-artige Solarzellen auf einem Substrat, insbesondere Glassubstrat, mit einem vom Substrat ausgehenden wesentlichen Schichtaufbau in der Folge:
Metallschicht, umfassend wenigstens eines der Metalle Molybdän, Niob, Kupfer, Nickel, Silber und Aluminium,
Schicht aus der Gruppe Kupferindiumdiselenid, Kupferindiumgalliumdiselenid, Kupfergalliumdiselenid und Kupferindiumsulfid,
Schicht aus der Gruppe Kadmiumzinksulfid, Kadmiumtellurid, Kadmiumsulfid, Zinksulfid und Zink-Magnesium-Oxid,
transparente leitfähige Oxidbeschichtung, die eine untere Schicht mit einer geringer Leitfähigkeit und daran anschließend eine obere Schicht mit einer hohen Leitfähigkeit aufweist, und
gegebenenfalls eine Antireflexionsschicht,
wobei die transparente leitfähige Oxidbeschichtung entsprechend der erfindungsgemäßen Oxidbeschichtung aufgebaut ist. CIGS-artig bedeutet also in diesem Zusammenhang, dass eine der Absorberschichten Kupferindiumdiselenid, Kupferindiumgalliumdiselenid,
Kupfergalliumdiselenid und Kupferindiumsulfid zum Einsatz kommt.
Zum anderen für CdTe-artige Solarzellen auf einem Substrat, insbesondere Glassubstrat, mit einem vom Substrat ausgehenden wesentlichen Schichtaufbau in der Folge:
transparente leitfähige Oxidbeschichtung, die eine untere Schicht mit einer hohen Leitfähigkeit und daran anschließend eine obere Schicht mit einer geringen Leitfähigkeit aufweist, Kadmiumsulfidschicht,
Kadmiumtelluridschicht und
Metallschicht, umfassend wenigstens einem der Metalle Molybdän, Niob, Kupfer, Nickel, Silber und Aluminium, wobei die transparente leitfähige Oxidbeschichtung entsprechend der erfindungsgemäßen Oxidbeschichtung aufgebaut ist.

Bevorzugt weist die Schicht mit geringer Leitfähigkeit eine Dicke von 20 bis 100 nm, insbesondere von 50 nm auf.

Weitere Vorteile der vorliegenden Erfindung werden deutlich anhand der nachfolgenden Beschreibung der in der Zeichnung abgebildeten Ausführungsbeispiele. Dabei zeigen rein schematisch
- Fig. 1: eine Vakuumbeschichtungskammer zur Durchführung des erfindungsgemäßen Verfahrens,
- Fig. 1a: eine alternative Vakuumbeschichtungskammer zur Durchführung des erfindungsgemäßen Verfahrens,
- Fig. 2: das Schichtsystem einer mit dem erfindungsgemäßen Verfahren hergestellten CIGS-Solarzelle,
- Fig. 3: das Schichtsystem einer mit dem erfindungsgemäßen Verfahren hergestellten CdTe-Solarzelle,
- Fig. 4: Darstellung der Abhängigkeit des spezifischen Widerstands vom Sauerstoffgehalt der Prozessgasatmosphäre von durch MF-Sputtern erzeugter ZnO:Al-Schichten niedriger Leitfähigkeit nach dem erfindungsgemäßen Verfahren.

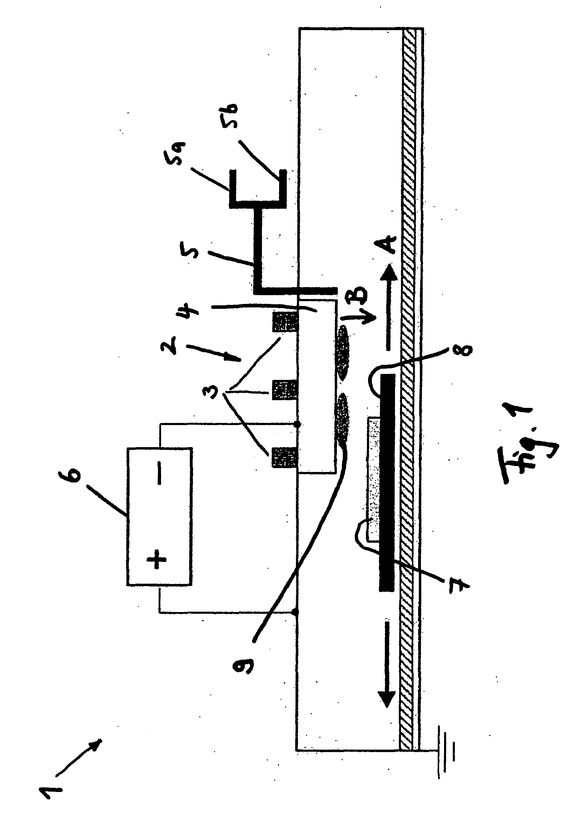

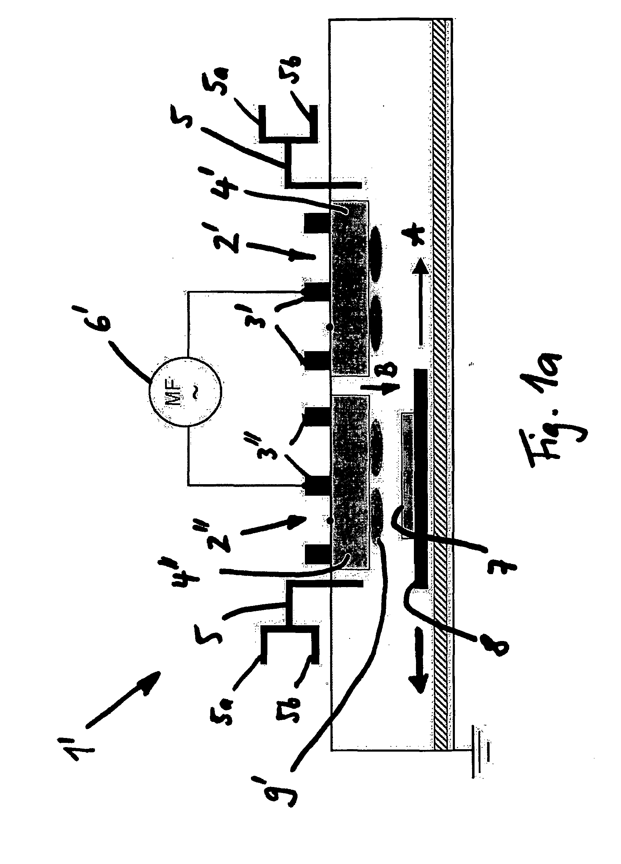

In Fig. 1 ist rein schematisch eine Vakuumbehandlungskammer 1 abgebildet, die zur Durchführung des erfindungsgemäßen Verfahrens Verwendung findet. Die Kammer weist eine DC-Sputterquelle 2 auf, von der schematisch nur der Magnetsatz 3 und das Target 4 dargestellt sind. Das Target 4 ist ein keramisches Target, das aus Zinkoxid und Aluminiumoxid besteht. Es ist als Planartarget ausgeführt, kann jedoch auch zylindrisch als Bestandteil einer rotierbaren Kathode ausgeführt sein. Mit Prozessgas gespeist werden kann die Sputterquelle 2 über eine Gaszuführung 5 zum einen über einen ersten Gasanschluß 5a entweder mit reinem Sauerstoff oder einem Inertgas-Sauerstoffgemisch, wobei hier ein Argon-Sauerstoffgemisch bevorzugt wird, und zum anderen über einen zweiten Gasanschluß 5b mit reinem Inertgas, wobei Argon bevorzugt wird. Die Speisung wird geregelt über jeweilige MFC (nicht gezeigt). Weiterhin wird die Sputterquelle 2 elektrisch über eine gepulste DC-Spannungsversorgung 6 gespeist, wobei die Versorgung bei geringen Leistungsdichten aber auch ungepulst erfolgen könnte.

Unterhalb der Sputterquelle 2 ist ein Substrat 7 auf einem Substrathalter (Carrier) 8 angeordnet, der gegenüber der Sputterquelle 2 in einer Richtung A senkrecht zur Beschichtungsrichtung B verfahrbar ist. Das Verfahren des Carriers 8 wird automatisch gesteuert. Statt eines einzigen Substrates 7 kann auch eine Vielzahl von Substraten in dem Carrier aufgenommen sein, um eine gleichzeitige Beschichtung zu ermöglichen. Die Substratkammer 1 kann in Verfahrrichtung A wiederum mit weiteren Substratkammern (nicht gezeigt) vakuumdicht über Schleusen (nicht gezeigt) verbunden sein, in denen ebenfalls Beschichtungswerkzeuge angeordnet sind, um weitere Schichten zu erzeugen. Es ist natürlich auch möglich ein Transportsystem einer In-Line - Anlage so auszulegen, dass die Substrate durch die Anlage befördert werden, ohne in einem Carrier aufgenommen zu sein.

Im Betrieb der Sputterquelle 2 stellt sich unterhalb des Targets 4 ein Plasma 9 ein, wodurch ein Beschichtungsprozess in Gang gesetzt wird, durch den das Substrat 7 beschichtet wird.

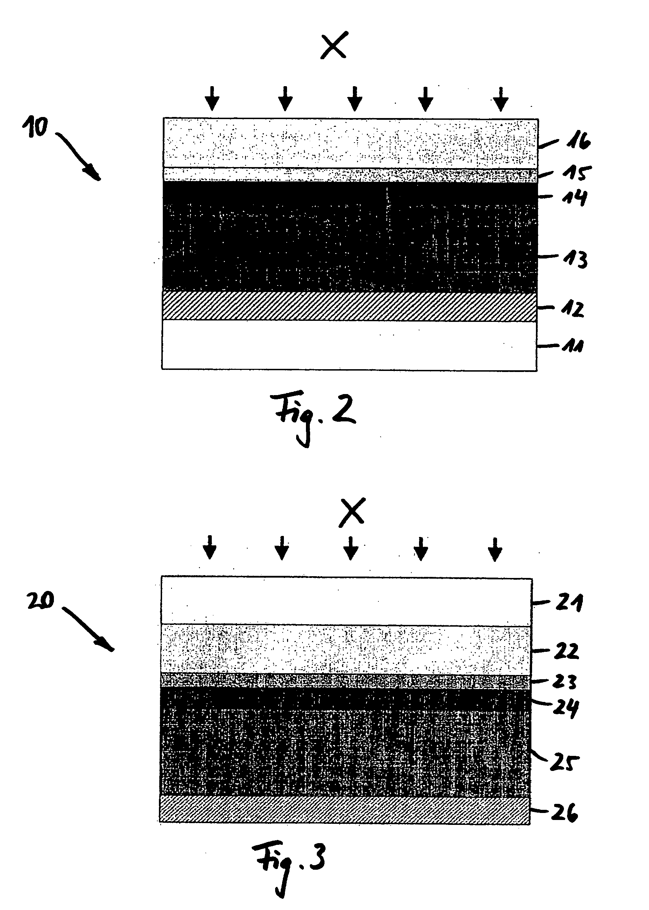

Die Erzeugung der erfindungsgemäßen transparenten leitfähigen Oxidbeschichtung wird nun anhand der in Fig. 2 schematisch dargestellten CIGS-Solarzelle 10 erläutert.

Nachdem auf dem Glassubstrat 11 eine Molybdänschicht 12, eine CIGS-Schicht 13 und eine CdTe-Pufferschicht 14 aufgebracht worden sind, wird das Substrat 11 in die Vakuumbehandlungskammer 1 befördert und unterhalb der Sputterquelle 2 platziert (siehe Fig. 1). Zur Aufbringung der erfindungsgemäßen transparenten leitfähigen Oxidbeschichtung wird die Sputterquelle 2 mit einem Argon-Sauerstoffgemisch über den Gasanschluss 5a gespeist und mit gepulster oder ungepulster DC-Spannung betrieben. Der Sauerstoffgehalt wird mit nicht mehr als 1% eingestellt, wobei es sich um Volumenprozent handelt. Dadurch wird eine Aluminium dotierte Zinkoxidschicht 15 mit einer sehr geringen Leitfähigkeit auf der Pufferschicht 14 abgeschieden. Nachdem diese Schicht 15 eine Dicke von 50 nm erreicht hat, wird darauf eine weitere Aluminium dotierte Zinkoxidschicht 16 abgeschieden, allerdings in einer reinen Argonatmosphäre oder einer Ar/O₂-Atmosphäre mit deutlich geringerem O₂-Gehalt (typisch maximal 0,1 %). Diese Schicht 16 weist eine hohe Leitfähigkeit auf und dient später als Kontakt für die Solarzelle 10. Anschließend kann die Kontaktschicht 16 noch mit einer Antireflexionsschicht (nicht gezeigt) versehen werden, wodurch sich die Grenzflächenverluste verringern und die Ausbeute der Solarzelle 10 in Bezug auf das eingestrahlte Sonnenlicht X erhöht.

Die kleine Menge Sauerstoff von maximal 0,1 % beim Abscheiden der Schicht 16 mit hoher Leitfähigkeit kann erforderlich sein, um den Verlust an Sauerstoff auszugleichen, der beim Sputterprozess mit reinem Argon im Targetmaterial verloren gehen könnte. Dagegen wird für das erfindungsgemäße Verfahren zur Herstellung der Schicht 15 mit sehr geringer Leitfähigkeit ein Sauerstoffgehalt von ca. 1 % benötigt. Der Unterschied zwischen 0,1 % und 1 % scheint auf den ersten Blick nicht gravierend zu sein, dennoch wirkt er sich stark auf die Leitfähigkeit aus.

Wenn, wie in Fig. 1 dargestellt, das Substrat 7 gegenüber dem Plasma 9 eine relativ große laterale Ausdehnung ausweist, so dass eine gleichmäßige Beschichtung nicht sichergestellt werden kann, ist vorgesehen, dass das Substrat 7 über den beweglichen Carrier 8 eine pendelnde Bewegung gegenüber dem Plasma 9 vollzieht bis die gewünschte Schichtdicke sich gleichmäßig einstellt. Zu diesem Zweck kann die pendelnde Bewegung des Carriers 8 auch ungleichmäßig oder diskontinuierlich vollzogen werden. Dieses pendelnde Verfahren ist besonders für kleinere Anlagen im Labormaßstab geeignet. In der industriellen Anwendung wird ein in-line-Verfahren (nicht gezeigt) bevorzugt, bei dem mehrere gleichartige Sputterquellen in Reihe angeordnet sind und das Substrat sukzessive an diesen Quellen vorbeigeführt wird. Die Transportgeschwindigkeit des Substrates wird dann an die Beschichtungsrate und die gewünschte Schichtdicke angepasst.

Statt eines DC-Sputterverfahrens mit einer Sputterquelle kann auch MF-Sputtern von mindestens zwei Kathoden verwendet werden, wie in Fig. 1a rein schematisch dargestellt ist,
wobei gleiche Bezugszeichen wie in Fig. 1 gleiche Teile bezeichnen.

Die für das MF-Sputterverfahren verwendete Vakuumbehandlungskammer 1' weist zwei gleichartige Sputterquellen 2', 2" auf mit Magnetsätzen 3', 3" und Targets 4', 4", die mit den Gaszuführungen 5 gespeist werden. Die Targets 4' sind jeweils wieder planare keramische Targets aus Zinkoxid und Aluminiumoxid. Als Versorgung dient ein MF-Generator 6', der die benötigten Frequenzen im Bereich von 10 kHz bis 100 kHz, bevorzugt von 40 kHz bereit stellt. Jedes der Targets 4', 4" wirkt abwechselnd als Anode und Kathode, so dass Prozessinstabilitäten dadurch beseitigt werden, dass jedes Target in der Zeit, in der es als Kathode wirkt, wieder freigesputtert wird und so das Problem einer verschwindenden Anode nicht auftritt. Auch mit diesem Doppelmagnetron-Sputterverfahren werden so die Nachteile des RF-Sputterns weitgehend vermieden.

Wie beim DC-Sputtern in Fig. 1 kann das MF-Sputtern sowohl im Pendelbetrieb als auch im in-line-Betrieb angewendet werden.

Während früher eine i-ZnO-Schicht vom undotierten Target durch aufwendiges RF-Sputtern mit niedriger Abscheiderate abgeschieden wurde, ist zu erkennen, dass mit dem erfindungsgemäßen Verfahren zum einen die Zinkoxidschicht 15 mit geringer Leitfähigkeit im Vergleich wesentlich schneller mit dem weniger aufwendigem DC-Sputtern (DC-Sputtern, gepulstes DC-Sputtern oder MF-Sputtern) abgeschieden werden kann, so dass sich der Herstellungsvorgang der Solarzelle 10 insgesamt beschleunigt und damit ihre Herstellung verbilligt. Die Anlagekosten werden so reduziert, da kein teurer RF-Generator mit Anpassungsnetzwerk und keine RF-tauglichen Kathoden benutzt werden müssen. Außerdem kann für beide Beschichtungsvorgänge beim Aufbringen der TCO-Schicht das gleiche Substratmaterial, ZnO:Al₂O₃, und zudem auch die gleiche Sputterquelle 2 verwendet werden. Dadurch könnte die Herstellung der TCO-Schicht auch in einer einzelnen Vakuumkammer 1 vorgenommen werden. Die Material- und Anlagenkosten also wesentlich reduziert.

Auch andere Solarzellen, wie beispielsweise CdTe-basierte Solarzellen 20 können mit dem erfindungsgemäßen Verfahren ebenfalls mit einer TCO-Schicht versehen werden. Hierzu wird nur die Reihenfolge der Abscheidung der beiden Zinkoxidschichten vertauscht, wie in Fig. 3 nachzuvollziehen ist.

Eine erfindungsgemäße CdTe-Solarzelle 20 ist demnach so aufgebaut, dass auf einem Glassubstrat 21 eine ZnO:Al-Schicht 22 mit hoher Leitfähigkeit abgeschieden ist, darauf anschließend eine ZnO:Al-Schicht 23 mit niedriger Leitfähigkeit, anschließend eine CdS-Pufferschicht 24, eine CdTe-Absorberschicht 25 und schließlich eine Metallkontaktschicht 26 aus Molybdän.

Die Solarzellen 10, 20 nach Fig. 2 und 3 stellen selbstverständlich nur typisierte Solarzellen 10, 20 dar mit einem typischen Schichtaufbau, der natürlich auch abgewandelt werden kann. Im Schichtaufbau können weitere Schichten vorgesehen und im Austausch auch andere Schichtmaterialien enthalten sein. So kann die Schicht mit hoher Leitfähigkeit auch eine andere Schicht als die ZnO:Al-Schicht 16, 22 sein, z.B. eine ITO-Schicht, wobei insbesondere bei CdTe-artigen Solarzellen auch Zinnoxid (SnO₂) und Kadmiumstannat (Cd₂SnO₄) in Frage kommen, sowie Galliumoxid (Ga₂O₃) und Zinkstannat (Zn₂SnO₄). Zudem können zwischen der Schicht mit hoher 16, 22 und der mit geringer Leitfähigkeit 15, 23 ein oder mehrere weitere Schichten mit hoher Leitfähigkeit vorgesehen sein. Schließlich kann die Absorberschicht 13 der CIGS-artigen Solarzelle auch aus Kupferindiumdiselenid, Kupfergalliumdiselenid und Kupferindiumsulfid gebildet sein, während die Pufferschicht 14 aus Kadmiumzinksulfid, Kadmiumtellurid, Kadmiumsulfid, Zinksulfid (ZnS) oder Zink-Magnesium-Oxid ((Zn,Mg)O) bestehen kann.

Wesentlich ist einzig, dass die Schicht 15, 23 mit niedriger Leitfähigkeit der TCO-Schicht das Aluminium dotierte Zinkoxid umfasst, das mittels DC-Sputtern unter zumindest teilweiser Sauerstoffatmosphäre erzeugt wurde.

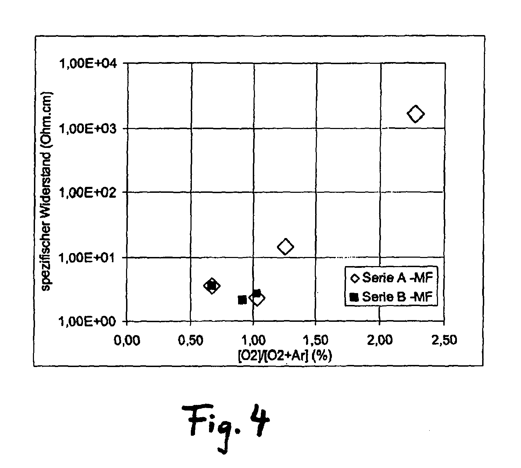

In Fig. 4 ist die Abhängigkeit des spezifischen Widerstands vom Sauerstoffgehalt der Prozessgasatmosphäre für ZnO:Al-Schichten niedriger Leitfähigkeit dargestellt, die nach dem erfinddungsgemäßen Verfahren mittels MF-Sputtern hergestellt wurden. Diese Abhängigkeit wurde für zwei verschiedene Serien ermittelt, die die gute Reproduzierbarkeit der Ergebnisse aufzeigen. Die einzelnen Herstellungsparameter sind in Tabelle 1 zusammengefasst.

**Tabelle 1:**

| **Probe** | **Leistung** | | **Gase** | | | **Schichteigenschaften** | | | |
|---|---|---|---|---|---|---|---|---|---|
| | **Leistung (kW)** | **Leistungsdichte (W pro cm Targotlänge)** | **Ar-Fluss (sccm)** | **Fluss 10% O2 in Ar (sccm)** | **O2-Gehalt: [O2]/[Ar+O2] (%)** | **Schichtdicke (nm)** | **dynamische Rate (nm.m/min)** | **Schichtwiderstand auf Glas (Ohm/sq)** | **Spez. Widersta nd (Ohm.cm)** |
| **Serie A-MF** | | | | | | | | | |
| | 3,8 | 77,9 | 70 | 20 | 2,27 | 82 | 31,98 | 2,00E+08 | 1,64E+03 |
| | 2,3 | 47,1 | 70 | 10 | 1,27 | 36 | 14,04 | 4,00E+06 | 1,44E+01 |
| | 3,2 | 65,6 | 70 | 5 | 0,67 | 50 | 19,5 | 7,00E+05 | 3,50E+00 |
| | 3,2 | 65,6 | 70 | 8 | 1,04 | 49 | 19,11 | 4,60E+05 | 2,25E+00 |
| Serie **B-MF** | | | | | | | | | |
| | 3,2 | 65,6 | 70 | 8 | 1,04 | 48 | 18,7 | 5,50E+05 | 2.64E+00 |
| | 1,6 | 32,8 | 70 | 5 | 0,67 | 50 | 6,5 | 7,00E+05 | 3,50E+00 |
| | 3,2 | 65,6 | 100 | 10 | 0,92 | 61 | 23,8 | 3,40E+05 | 2,07E+00 |

Anhand der vorstehenden Ausführungen ist klar geworden, dass mithilfe der vorliegenden Erfindung sich auf besonders einfache und kostengünstige Weise TCO-Schichten verwirklichen lassen, die eine Zinkoxidschicht 15, 23 mit geringer Leitfähigkeit beinhalten. Dadurch lassen sich beispielsweise Dünnschichtsolarzellen 10, 20, bei denen diese TCO-Schichten als transparente elektrisch leitende Kontakte eingesetzt werden, wesentlich kostengünstiger herstellen. Diese TCO-Schichten können aber auch in anderen Bauelementen eingesetzt werden.

## Patentansprüche

1. Verfahren zur Erzeugung einer transparenten leitfähigen Oxidbeschichtung, insbesondere einer transparenten leitfähigen Oxidbeschichtung als transparenter Kontakt für Dünnschichtsolarzellen (10; 20), die mindestens eine erste Schicht (16; 22) mit einer hohen Leitfähigkeit und eine zweite Schicht (15; 23) mit einer wesentlich geringeren Leitfähigkeit umfasst,
**dadurch gekennzeichnet, dass**
die zweite Schicht (15; 23) durch DC-Sputtern von mindestens einem Target (4) erzeugt wird, das Zinkoxid und zusätzlich Aluminium, Indium, Gallium oder Bor oder ihre Kombination aufweist, wobei die Prozessatmosphäre Sauerstoff enthält.

2. Verfahren nach Anspruch 1,
**dadurch gekennzeichnet, dass**
der Sauerstoffgehalt in der Prozessatmosphäre höchstens 3%, insbesondere höchstens 2% beträgt und bevorzugt im Bereich von höchstens 1% und minimal 0,2% liegt.

3. Verfahren nach Anspruch 1 oder 2,
**dadurch gekennzeichnet, dass**
die Prozessatmosphäre Argon oder ein anderes Inertgas enthält.

4. Verfahren nach einem der vorherigen Ansprüche,
**dadurch gekennzeichnet, dass**
die zweite Schicht (15; 23) mittels gepulstem DC-Sputtern erzeugt wird.

5. Verfahren nach einem der Ansprüche 1 bis 3,
**dadurch gekennzeichnet, dass**
die zweite Schicht (15; 23) mittels MF-Sputtern von einer Doppelkathode erzeugt wird.

6. Verfahren nach einem der vorherigen Ansprüche,
**dadurch gekennzeichnet, dass**
die erste Schicht (16; 22) Aluminium dotiertes Zinkoxid umfasst, das mittels DC-Sputtern erzeugt wurde.

7. Verfahren nach einem der vorherigen Ansprüche,
**dadurch gekennzeichnet, dass**
als Target (4) des Sputterns der zweiten Schicht (15; 23) ein keramisches ZnO:Al₂O₃-Target verwendet wird.

8. Verfahren nach einem der vorherigen Ansprüche,
**dadurch gekennzeichnet, dass**
sowohl die erste (16; 22) als auch die zweite Schicht (15; 23) durch Sputtern vom gleichen Target (4) erzeugt werden, wobei die erste Schicht (15; 23) in einer Inertgasatmosphäre und die zweite Schicht (15; 23) in einer gemischten Inertgas-Sauerstoff-Prozessatmosphäre erzeugt werden.

9. Verfahren nach einem der vorherigen Ansprüche,
**dadurch gekennzeichnet, dass**
das insbesondere auch mit einer Beschichtung versehene Substrat (7), auf dem die transparenten leitfähigen Oxidbeschichtung abgeschieden werden soll, eine pendelnde Bewegung in einer hinsichtlich der Abscheiderichtung (B) der Sputterquelle (2) senkrechten Richtung (A) ausführt.

10. Verfahren nach einem der Ansprüche 1 bis 8,
**dadurch gekennzeichnet, dass**
das insbesondere auch mit einer Beschichtung versehene Substrat (7), auf dem die transparenten leitfähigen Oxidbeschichtung abgeschieden werden soll, an mehreren Sputterquellen (2) vorbeigeführt wird, um die notwenige Schichtdicke im in-line-Betrieb zu erzeugen.

11. Verfahren nach einem der vorherigen Ansprüche,
**dadurch gekennzeichnet, dass**
ein Substrat (11), insbesondere Glassubstrat, auf dem sich ein vom Substrat (11) ausgehender wesentlicher Schichtaufbau mit einer Metallschicht (12) mit wenigstens einem der Metalle Molybdän, Niob, Kupfer, Nickel, Silber und Aluminium, einer Schicht (13) aus der Gruppe Kupferindiumdiselenid, Kupferindiumgalliumdiselenid, Kupfergalliumdiselenid und Kupferindiumsulfid, einer weiteren Schicht (14) aus der Gruppe Kadmiumzinksulfid, Kadmiumtellurid, Kadmiumsulfid, Zinksulfid und Zink-Magnesium-Oxid befindet, mit der zweiten Schicht (15) mit geringer Leitfähigkeit und anschließend mit der ersten Schicht (16) mit hoher Leitfähigkeit beschichtet wird.

12. Verfahren nach einem der Ansprüche 1 bis 10,
**dadurch gekennzeichnet, dass**
ein Substrat (21), insbesondere Glassubstrat, mit der ersten Schicht (22) mit hoher Leitfähigkeit und anschließend mit der zweiten Schicht (23) mit geringer Leitfähigkeit beschichtet wird und weiterhin ein vom Substrat (21) ausgehender wesentlicher Schichtaufbau mit einer Kadmiumsulfidschicht (24), einer Kadmiumtelluridschicht (25) und einer Metallschicht (26) mit wenigstens einem der Metalle Molybdän, Niob, Kupfer, Nickel, Silber und Aluminium aufgebracht wird.

13. Transparente leitfähige Oxidbeschichtung, insbesondere als transparenter Kontakt für Dünnschichtsolarzellen (10; 20), die mindestens eine erste Schicht (16; 22) mit einer hohen Leitfähigkeit und eine zweite Schicht (15; 23) mit einer wesentlich geringeren Leitfähigkeit umfasst,
**dadurch gekennzeichnet, dass**
die zweite Schicht (15; 23) Aluminium dotiertes Zinkoxid umfasst, das in einer Prozessatmosphäre, die Sauerstoff enthält, abgeschieden wurde, insbesondere hergestellt nach dem Verfahren nach einem der Ansprüche 1 bis 12.

14. Oxidbeschichtung nach Anspruch 13,
**dadurch gekennzeichnet, dass**
die zweite Schicht (15; 23) eine Schichtdicke im Bereich von 20 nm bis 100 nm, bevorzugt von 50 nm aufweist.

15. Oxidbeschichtung nach Anspruch 13 oder 14,
**dadurch gekennzeichnet, dass**
zwischen der ersten (16; 22) und der zweiten Schicht (15; 23) weitere Schichten angeordnet sind, die ebenfalls eine hohe Leitfähigkeit aufweisen.

16. Dünnschichtsolarzelle (10) auf einem Substrat (11), insbesondere Glassubstrat, mit einem vom Substrat (11) ausgehenden wesentlichen Schichtaufbau in der Folge:
Metallschicht (12) umfassend wenigstens eines der Metalle Molybdän, Niob, Kupfer, Nickel, Silber und Aluminium,
Schicht (13) aus der Gruppe Kupferindiumdiselenid, Kupferindiumgalliumdiselenid, Kupfergalliumdiselenid und Kupferindiumsulfid,
Schicht (14) aus der Gruppe Kadmiumzinksulfid, Kadmiumtellurid, Kadmiumsulfid, Zinksulfid und Zink-Magnesium-Oxid,
transparente leitfähige Oxidbeschichtung, die eine untere Schicht (15) mit einer geringeren Leitfähigkeit und daran anschließend eine obere Schicht (16) mit einer hohen Leitfähigkeit aufweist, und
gegebenenfalls eine Antireflexionsschicht,
**dadurch gekennzeichnet, dass**
die transparente leitfähige Oxidschicht nach einem der Ansprüche 13 bis 15 aufgebaut ist, wobei die obere Schicht (16) der ersten Schicht entspricht und die untere Schicht (15) der zweiten Schicht.

17. Dünnschichtsolarzelle (20) auf einem Substrat (21), insbesondere Glassubstrat, mit einem vom Substrat (21) ausgehenden wesentlichen Schichtaufbau in der Folge:
transparente leitfähige Oxidbeschichtung, die eine untere Schicht (22) mit einer hohen Leitfähigkeit und daran anschließend eine obere Schicht (23) mit einer geringen Leitfähigkeit aufweist, sowie
Kadmiumsulfidschicht (24),
Kadmiumtelluridschicht (25) und
Metallschicht (26) mit wenigstens einem der Metalle Molybdän, Niob, Kupfer, Nickel, Silber und Aluminium.
**dadurch gekennzeichnet, dass**
die transparente leitfähige Oxidschicht nach einem der Ansprüche 13 bis 15 aufgebaut ist, wobei die untere Schicht (22) der ersten Schicht entspricht und die obere Schicht (23) der zweiten Schicht.

18. Dünnschichtsolarzelle (10; 20) nach Anspruch 16 oder 17,
**dadurch gekennzeichnet, dass**
die Schicht (15; 23) mit geringer Leitfähigkeit eine Dicke von 50 bis 100 nm aufweist.
